# EUROPEAN PATENT APPLICATION

(11) **EP 4 199 678 A1**
(43) Date of publication of application: **21.06.2023**
(21) Application number: 22201781.6
(22) Date of filing: 17.10.2022
(51) Int. Cl.: H10K 30/20, H10K 39/32, G02B 6/42

(54) **ORGANIC THIN-FILMS FOR DATA TRANSMISSION**

(30) Priority: 20.12.2021 US 202117556768
(71) Applicant: INTEL Corporation, Santa Clara, CA 95054 (US)
(72) Inventor: Marin, Brandon C., Chandler, 85225 (US); Ecton, Jeremy D., Gilbert, 85298 (US); Pietambaram, Srinivas, Chandler, 85249 (US); Darmawikarta, Kristof, Chandler, 85249 (US)
(74) Representative: Goddar, Heinz J.

(57) **Abstract**

Disclosed herein are organic semiconductors using optical signaling on a microelectronics package and methods for manufacturing the same. The microelectronics packages may include a substrate, an acceptor, a donor, and a solder resist layer. The substrate may include a trace. The acceptor may be in electrical communication with the trace. The donor may be connected to the acceptor. The solder resist layer may be connected to the substrate and encapsulate a portion of at least the acceptor.

## Description

### FIELD OF THE DISCLOSURE

The present subject matter relates to microelectronics packages. More specifically, the present disclosure relates to organic thin films for data transmission in optical co-packaging in microelectronics package applications.

### BACKGROUND

Off-package input/output (I/O) bandwidth has been steadily increasing over the years. Packaging and I/O technologies need to scale to meet this bandwidth demand. As a result, package pin counts and I/O data rates have continued to increase. However, electrical I/O reach (length of electrical printed circuit board (PCB) trace or cable) continues to reduce as data rates increase. Additionally, I/O energy efficiency improvement has drastically slowed, which has resulted in a quickly approaching I/O power wall for high-performance packages.

### BRIEF DESCRIPTION OF THE FIGURES

In the drawings, which are not necessarily drawn to scale, like numerals may describe similar components in different views. Like numerals having different letter suffixes may represent different instances of similar components. The drawings illustrate generally, by way of example, but not by way of limitation, various embodiments discussed in the present document.
FIG. 1A shows an optical device of a microelectronics package in accordance with at least one example of this disclosure.
FIG. 1B shows a detail of an optical device in accordance with at least one example of this disclosure.
FIG. 2 shows a schematic of a microelectronics package in accordance with at least one example of this disclosure.
FIGS. 3A and 3B show a process flow for manufacturing an optical device in accordance with at least one example of this disclosure.
FIG. 4 shows system level diagram in accordance with at least one example of this disclosure.

### DETAILED DESCRIPTION

As disclosed herein, electrical solutions may include 1) circuit design optimizations, 2) CMOS process scaling, 3) reducing channel loss characteristics through improving PCB materials, packaging technology, sockets and connectors, and 4) increase package size and pin counts. Additionally, competing co-packaged optical solutions may use EMIB technology to connect compute silicon and photonic IC. Solid state materials may also be used to facilitate optical transmission and receipt. Currently used solid state materials, such as InGaAs photodetectors and III-V materials used in µ-LEDs, are expensive and difficult to fabricate.

The systems and methods disclosed herein may use organic semiconductors materials as photodetectors and organic light emission devices (OLED). These materials may provide a cheap alternative to conventional solid state device. As disclosed herein, these organic materials may be used for optical data transmission, thus, allowing for higher bandwidth and throughput. This may translate to higher performance products at a lower cost.

Consistent with embodiments disclosed herein, microelectronics packages may include a substrate that includes a trace. An acceptor may be in electrical communication with the trace and a donor may be connected to the acceptor. A photolithographic masking material, such as a solder resist layer, may be connect to the substrate and encapsulating a portion of at least the acceptor. A lens may be positioned proximate an opening defined by the photolithographic masking material and exposed to the donor. A fiber optic cable may be in optical communication with the donor and an optical engine in optical communication with the donor, such as via the fiber optic cable.

As disclosed herein, the acceptor may be an organic substrate material. The donor may also be an organic substrate material. Consistent with embodiments disclosed herein, either or both of the acceptor and the donor may be manufactured of a non-silicon-based substrates. Non-limiting examples of materials for acceptors and donors may include an alkyl thiphenes and/or polybuckminsterfullerene.

The above discussion is intended to provide an overview of subject matter of the present patent application. It is not intended to provide an exclusive or exhaustive explanation. The description below is included to provide further information.

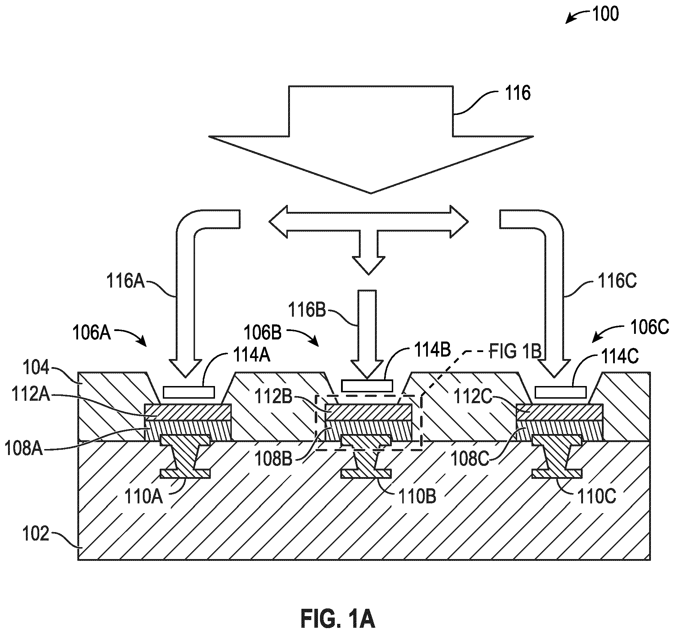

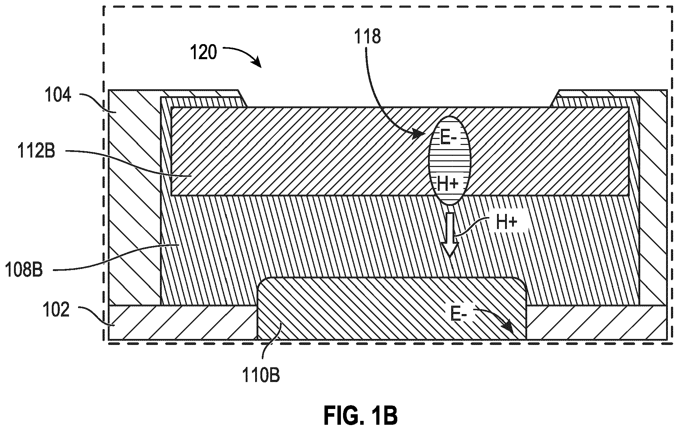

Turning now to the figures, FIG. 1 shows an optical device 100 in accordance with at least one example of this disclosure. Optical device 100 may include a substate 102 and a photolithographic masking material 104, such as a solder resist layer, that defines openings 106 (labeled individually as openings 106A, 106B, and 106C). Acceptors 108 (labeled individually as acceptors 108A, 108B, and 108C) may be attached to substrate 102 an in electrical communication with traces 110 (labeled individually as traces 110A, 110B, and 110C).

Donors 112 (labeled individually as donors 112A, 112B, and 112C) may be attached to corresponding acceptors 108. Lens 114 (labeled individually as lens 114A, 114B, and 114C) may be positioned proximate respective donors 112. As disclosed herein, a signal 116 may be supplied to donors 112. Signal 116 may be a single channel or multichannel signal. For example, and as shown in FIG. 1A, signal 116 may be a three channel signal that may be split into three components 116A, 116B, and 116C that may be directed to respective donors 112. As shown in FIG. 1B, acceptors 108 may partially encapsulate donors 112. The encapsulation may strengthen the bonding of acceptors 108 to donors 112. Acceptors 108 may also define openings 120 to allow signals 116 to reach donors 112.

As disclosed herein, acceptors 108 and donors 112 may be organic substrate materials. For example, in some examples, acceptors 108 and donors 112 may be separate layers of different organic materials. In other examples, each of acceptors 108 may be made of the same organic substrate material or made of different organic substrate materials. Each of donors 112 may be made of the same organic substrate material or made of different organic substrate materials. As an example, acceptors 108A and 108B may be made of a polyalkylthiophene and acceptor 108C may be made of polybuckminsterfullerene (PCBM). Donors 112A and 112B may be made of polybuckminsterfullerene while donor 112C may be made of polyalkylthiophene. Polyalkylthiophene contains sulfur (S) in addition to other elements and thus, in various examples either of acceptor or donor layers may include sulfur.

As disclosed herein, signal 116 may be light that is supplied to donors 112. Upon the light hitting donors 112, the donor material my absorb photons to make hole pairs 118. The hole pairs may be transmitted to the acceptor material. For example, donors 112 may be electron hole pairs in 3p orbital when donors 112 are p-type semiconductors. Acceptors 108 may take the hole pair and convert them to an electrical signal that may be carried via traces 110. To output information, donors 112 may act as acceptors to create hole pairs that are transmitted to acceptors 108, which in turn may act as donors to convert the hole pairs to light accepted by lenses 114. Stated another way, the light is converted into hole pairs 118 in the P3 orbital of donors 112. Acceptors 108 may transport the hole pairs 118 to the surface of acceptors 108 that is in contact with traces 110. The charge at the surface of traces 110 may cause a bias on traces 110, which causes a current (i.e., signal) to flow through traces 110.

As disclosed herein, acceptors 108 and donors 112 may be thin film organic semiconductors used in packaging. Acceptors 108 and donors 112 may form optical devices that may include photodetectors, which have been shown to have -3dB bandwidth loss at 450 MHz using standard alkyl thiophenes, and also photoemitters or OLEDs, which have been shown to have data transmission speeds of up to 1.17 GBps at 245 MHz using organic emitters like BDAVBi. These organic semiconductors are competitive with solid state counterparts. Thus, using the systema and methods disclosed herein, optical components that are cheaper than solid state counterparts may be used that are compatible with the thin film manufacturing processes utilized in packaging.

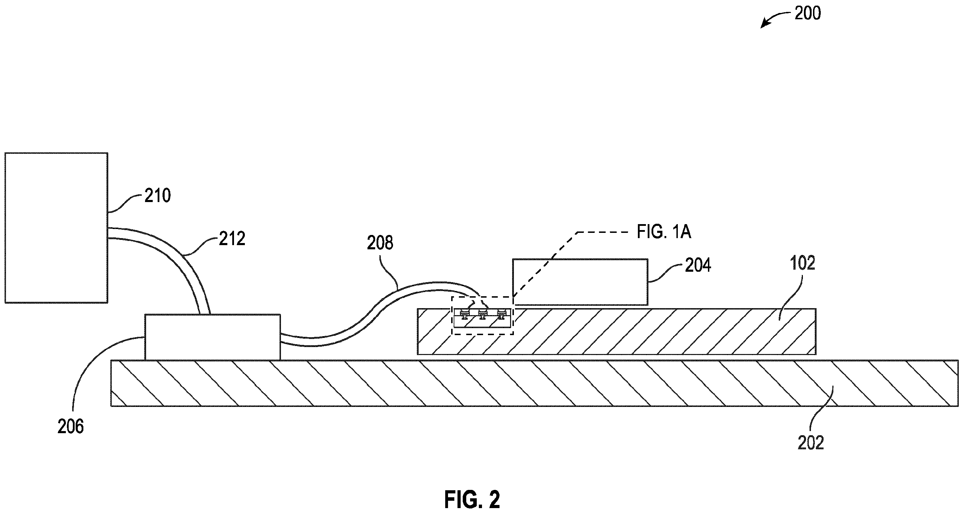

FIG. 2 shows a schematic of a microelectronics package 200 in accordance with at least one example of this disclosure. Microelectronics package 200 may include optical device 100, which may be attached to a motherboard 202, or other printed circuit board, such as, but not limited to a video card. Microelectronics package 200 may also include a compute die 204 that may be electrically coupled to optical device 100 via traces 110. Microelectronics package 200 may also include an optical engine 206 that may be coupled to optical device 100 via one or more fiber optic cables 208. For example, a single fiber optic cable may supply a multichannel signal or multiple fiber optic cables may supply individual signals to respective donors 112. Microelectronics package 200 may be connected to other networks, such as a fiber optic network 210 via one or more fiber optical cables 212.

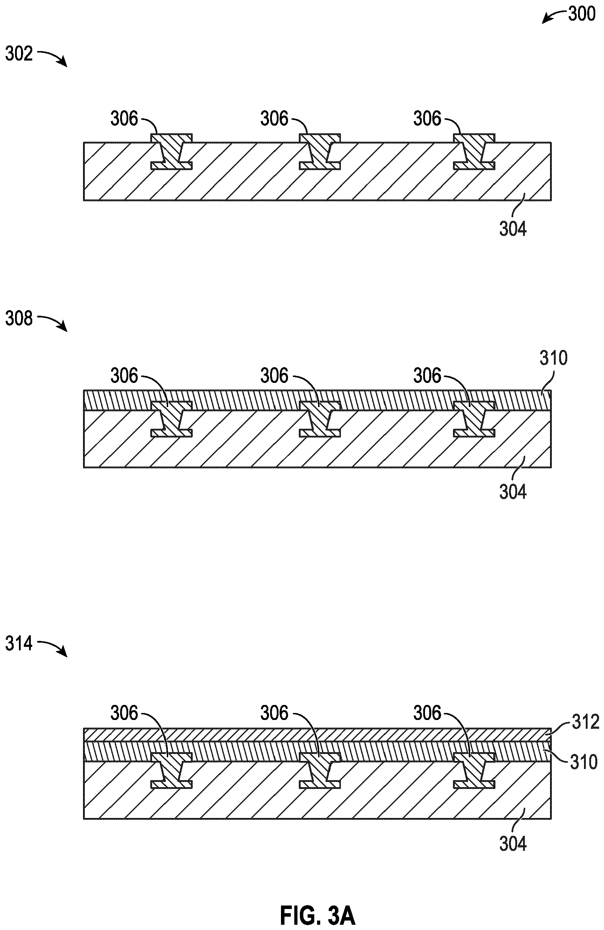

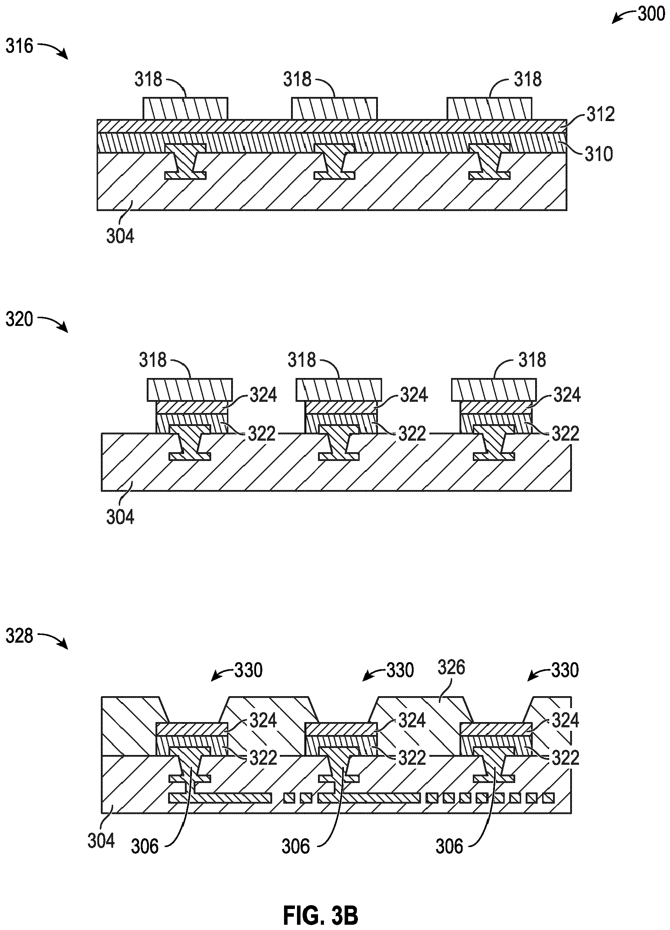

FIGS. 3A and 3B shows a process flow 300 for manufacturing an optical device, such as optical device 100, in accordance with at least one example of this disclosure. Process flow 300 may begin at stage 302, where a substrate 304 may be formed with one or more traces or vias 306. Substrate 304 may be formed on a carrier, such as a glass carrier, and traces or vias 306 may be copper traces, through vias, etc. that may be formed using any suitable techniques.

At stage 308 an acceptor layer 310 may be formed. Acceptor layer 310 may be made of organic substrate materials as disclosed herein. Acceptor layer 310 may also be a thin film material that is laid or otherwise placed on substrate 304. Once acceptor layer 310 is formed, a donor layer 312 may be formed in stage 314. Doner layer 312 may be made of organic substrate materials as disclosed herein and may be a thin film material that is laid or otherwise placed on acceptor layer 310.

At stage 316 dry film resist materials 318 may be deposited on doner layer 312. Once the dry file resist materials 318 are placed, both acceptor layer 310 and donor layer 312 may be dry etched (stage 320) to form individual acceptors 322 and donors 324, such as acceptors 108 and donors 112.

Once individual acceptors 322 and donors 324 are formed, they may be encapsulated in a solder resist material 326 (stage 328). Stage 328 may also include forming solder resist openings in solder resist material 326 to expose portions of individual donors 324 and/or donor layer 312.

As part of process flow 300, one or more lens, such as lenses 114, may be placed proximate openings 330 formed in solder resist material 326. Still consistent with embodiments disclosed herein, a portion of one or more fiber optic cables, such as a first end of the one or more fiber optic cables may be positioned proximate a donor surface of one or more of donors 324. The fiber optic cables may allow for the optically coupling of an optical engine with the donor surface of individual donors 324. A compute die, such as compute die 204 may be connected to traces 306.

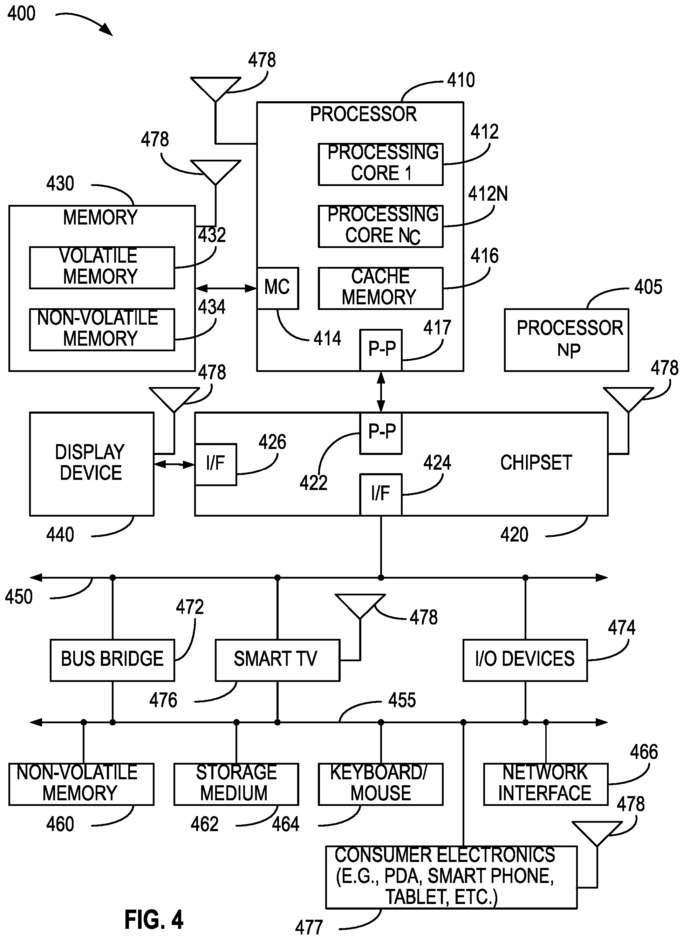

FIG. 4 illustrates a system level diagram, according to one embodiment of the invention. For instance, FIG. 4 depicts an example of an electronic device (e.g., system) including optical device 100 and/or microelectronics package 200 as described herein. FIG. 4 is included to show an example of a higher level device application for the present invention. In one embodiment, system 400 includes, but is not limited to, a desktop computer, a laptop computer, a netbook, a tablet, a notebook computer, a personal digital assistant (PDA), a server, a workstation, a cellular telephone, a mobile computing device, a smart phone, an Internet appliance or any other type of computing device. In some embodiments, system 400 is a system on a chip (SOC) system.

In one embodiment, processor 410 has one or more processing cores 412 and 412N, where 412N represents the Nth processor core inside processor 410 where N is a positive integer. In one embodiment, system 400 includes multiple processors including 410 and 405, where processor 405 has logic similar or identical to the logic of processor 410. In some embodiments, processing core 412 includes, but is not limited to, pre-fetch logic to fetch instructions, decode logic to decode the instructions, execution logic to execute instructions and the like. In some embodiments, processor 410 has a cache memory 416 to cache instructions and/or data for system 400. Cache memory 416 may be organized into a hierarchal structure including one or more levels of cache memory.

In some embodiments, processor 410 includes a memory controller 414, which is operable to perform functions that enable the processor 410 to access and communicate with memory 430 that includes a volatile memory 432 and/or a non-volatile memory 434. In some embodiments, processor 410 is coupled with memory 430 and chipset 420. Processor 410 may also be coupled to a wireless antenna 478 to communicate with any device configured to transmit and/or receive wireless signals. In one embodiment, the wireless antenna interface 478 operates in accordance with, but is not limited to, the IEEE 802.11 standard and its related family, Home Plug AV (HPAV), Ultra Wide Band (UWB), Bluetooth, WiMax, or any form of wireless communication protocol.

In some embodiments, volatile memory 432 includes, but is not limited to, Synchronous Dynamic Random Access Memory (SDRAM), Dynamic Random Access Memory (DRAM), RAMBUS Dynamic Random Access Memory (RDRAM), and/or any other type of random access memory device. Non-volatile memory 434 includes, but is not limited to, flash memory, phase change memory (PCM), read-only memory (ROM), electrically erasable programmable read-only memory (EEPROM), or any other type of non-volatile memory device.

Memory 430 stores information and instructions to be executed by processor 410. In one embodiment, memory 430 may also store temporary variables or other intermediate information while processor 410 is executing instructions. In the illustrated embodiment, chipset 420 connects with processor 410 via Point-to-Point (PtP or P-P) interfaces 417 and 422. Chipset 420 enables processor 410 to connect to other elements in system 400. In some embodiments of the invention, interfaces 417 and 422 operate in accordance with a PtP communication protocol such as the Intel^{®} QuickPath Interconnect (QPI) or the like. In other embodiments, a different interconnect may be used.

In some embodiments, chipset 420 is operable to communicate with processor 410, 405N, display device 440, and other devices 472, 476, 474, 460, 462, 464, 466, 477, etc. Chipset 420 may also be coupled to a wireless antenna 478 to communicate with any device configured to transmit and/or receive wireless signals.

Chipset 420 connects to display device 440 via interface 426. Display 440 may be, for example, a liquid crystal display (LCD), a plasma display, cathode ray tube (CRT) display, or any other form of visual display device. In some embodiments of the invention, processor 410 and chipset 420 are merged into a single SOC. In addition, chipset 420 connects to one or more buses 450 and 455 that interconnect various elements 474, 460, 462, 464, and 466. Buses 450 and 455 may be interconnected together via a bus bridge 472. In one embodiment, chipset 420 couples with a non-volatile memory 460, a mass storage device(s) 462, a keyboard/mouse 464, and a network interface 466 via interface 424 and/or 404, smart TV 476, consumer electronics 477, etc.

In one embodiment, mass storage device 462 includes, but is not limited to, a solid state drive, a hard disk drive, a universal serial bus flash memory drive, or any other form of computer data storage medium. In one embodiment, network interface 466 is implemented by any type of well known network interface standard including, but not limited to, an Ethernet interface, a universal serial bus (USB) interface, a Peripheral Component Interconnect (PCI) Express interface, a wireless interface and/or any other suitable type of interface. In one embodiment, the wireless interface operates in accordance with, but is not limited to, the IEEE 802.11 standard and its related family, Home Plug AV (HPAV), Ultra Wide Band (UWB), Bluetooth, WiMax, or any form of wireless communication protocol.

While the modules shown in FIG. 4 are depicted as separate blocks within the system 400, the functions performed by some of these blocks may be integrated within a single semiconductor circuit or may be implemented using two or more separate integrated circuits. For example, although cache memory 416 is depicted as a separate block within processor 410, cache memory 416 (or selected aspects of 416) can be incorporated into processor core 412.

### Additional Notes

The following, non-limiting examples, detail certain aspects of the present subject matter to solve the challenges and provide the benefits discussed herein, among others.

Example 1 is a microelectronics package comprising: a substrate including a trace; an acceptor in electrical communication with the trace; a donor connected to the acceptor; a solder resist layer connected to the substrate and encapsulating a portion of at least the acceptor.

In Example 2, the subject matter of Example 1 optionally includes a lens positioned proximate an opening defined by the solder resist layer and exposed to the donor.

In Example 3, the subject matter of any one or more of Examples 1-2 optionally include a fiber optic cable in optical communication with the donor.

In Example 4, the subject matter of any one or more of Examples 1-3 optionally include an optical engine in optical communication with the donor.

In Example 5, the subject matter of any one or more of Examples 1-4 optionally include a compute die connected to the trace.

In Example 6, the subject matter of any one or more of Examples 1-5 optionally include wherein the acceptor is an organic substrate material.

In Example 7, the subject matter of any one or more of Examples 1-6 optionally include wherein the donor is an organic substrate material.

In Example 8, the subject matter of any one or more of Examples 1-7 optionally include wherein both the acceptor and the donor are not silicon-based substrates.

In Example 9, the subject matter of any one or more of Examples 1-8 optionally include wherein the acceptor comprises at least one of an alkyl thiphenes and polybuckminsterfullerene.

In Example 10, the subject matter of any one or more of Examples 1-9 optionally include wherein the donor comprises at least one of an alkyl thiphenes and polybuckminsterfullerene.

Example 11 is a microelectronics package comprising: a substrate including a trace; an acceptor in electrical communication with the trace; a donor connected to the acceptor; a solder resist layer connected to the substrate and encapsulating a portion of at least the acceptor, the solder resist layer defining a cavity having an opening that exposes a portion of the donor.

In Example 12, the subject matter of Example 11 optionally includes a lens positioned proximate the opening defined by the solder resist layer and exposed to the donor.

In Example 13, the subject matter of any one or more of Examples 11-12 optionally include a fiber optic cable in optical communication with the donor.

In Example 14, the subject matter of any one or more of Examples 11-13 optionally include an optical engine in optical communication with the donor.

In Example 15, the subject matter of any one or more of Examples 11-14 optionally include a compute die connected to the trace.

In Example 16, the subject matter of any one or more of Examples 11-15 optionally include wherein the acceptor is an organic substrate material.

In Example 17, the subject matter of any one or more of Examples 11-16 optionally include wherein the donor is an organic substrate material.

In Example 18, the subject matter of any one or more of Examples 11-17 optionally include wherein both the acceptor and the donor are not silicon-based substrates.

In Example 19, the subject matter of any one or more of Examples 11-18 optionally include wherein the acceptor comprises at least one of an alkyl thiphenes and polybuckminsterfullerene.

In Example 20, the subject matter of any one or more of Examples 11-19 optionally include wherein the donor comprises at least one of an alkyl thiphenes and polybuckminsterfullerene.

Example 21 is a method of manufacturing a microelectronics package, the method comprising: forming a substrate layer having a substrate surface and a trace; forming an acceptor layer on the substrate surface, the acceptor layer having an acceptor surface; forming a donor layer on the acceptor surface, the donor layer having a donor surface; encapsulating the acceptor layer and the donor layer with a solder resist material; and forming a solder resist opening in the solder resist material to expose a portion of the donor surface.

In Example 22, the subject matter of Example 21 optionally includes wherein forming the solder resist opening comprises: forming a dry film resist layer on the donor surface prior to encapsulating the acceptor layer and the donor layer with the solder resist material; and removing the dry film resist layer to form the solder resist opening.

In Example 23, the subject matter of any one or more of Examples 21-22 optionally include positioning a lens proximate the solder resist opening.

In Example 24, the subject matter of any one or more of Examples 21-23 optionally include positioning a portion of a fiber optic cable proximate the donor surface.

In Example 25, the subject matter of any one or more of Examples 21-24 optionally include optically coupling an optical engine with the donor surface.

In Example 26, the subject matter of any one or more of Examples 21-25 optionally include connecting a compute die to the trace.

In Example 27, the subject matter of any one or more of Examples 21-26 optionally include wherein forming the acceptor layer comprises forming the acceptor layer with an organic substrate material.

In Example 28, the subject matter of any one or more of Examples 21-27 optionally include wherein forming the donor layer comprises forming the donor layer with an organic substrate material.

In Example 29, the subject matter of any one or more of Examples 21-28 optionally include wherein both the acceptor layer and the donor layer are not silicon-based substrates.

In Example 30, the subject matter of any one or more of Examples 21-29 optionally include wherein forming the acceptor layer comprises forming the acceptor layer with at least one of an alkyl thiphenes and polybuckminsterfullerene.

In Example 31, the subject matter of any one or more of Examples 21-30 optionally include wherein forming the donor layer comprises forming the donor layer with at least one of an alkyl thiphenes and polybuckminsterfullerene.

In Example 32, the microelectronics packages, systems, apparatuses, or method of any one or any combination of Examples 1 - 31 can optionally be configured such that all elements or options recited are available to use or select from.

The above detailed description includes references to the accompanying drawings, which form a part of the detailed description. The drawings show, by way of illustration, specific embodiments in which the invention can be practiced. These embodiments are also referred to herein as "examples." Such examples can include elements in addition to those shown or described. However, the present inventors also contemplate examples in which only those elements shown or described are provided. Moreover, the present inventors also contemplate examples using any combination or permutation of those elements shown or described (or one or more aspects thereof), either with respect to a particular example (or one or more aspects thereof), or with respect to other examples (or one or more aspects thereof) shown or described herein.

In the event of inconsistent usages between this document and any documents so incorporated by reference, the usage in this document controls.

In this document, the terms "a" or "an" are used, as is common in patent documents, to include one or more than one, independent of any other instances or usages of "at least one" or "one or more." In this document, the term "or" is used to refer to a nonexclusive or, such that "A or B" includes "A but not B," "B but not A," and "A and B," unless otherwise indicated. In this document, the terms "including" and "in which" are used as the plain-English equivalents of the respective terms "comprising" and "wherein." Also, in the following claims, the terms "including" and "comprising" are open-ended, that is, a system, device, article, composition, formulation, or process that includes elements in addition to those listed after such a term in a claim are still deemed to fall within the scope of that claim. Moreover, in the following claims, the terms "first," "second," and "third," etc. are used merely as labels, and are not intended to impose numerical requirements on their objects.

The above description is intended to be illustrative, and not restrictive. For example, the above-described examples (or one or more aspects thereof) may be used in combination with each other. Other embodiments can be used, such as by one of ordinary skill in the art upon reviewing the above description. The Abstract is provided to comply with 37 C.F.R. §1.72(b), to allow the reader to quickly ascertain the nature of the technical disclosure. It is submitted with the understanding that it will not be used to interpret or limit the scope or meaning of the claims. Also, in the above Detailed Description, various features may be grouped together to streamline the disclosure. This should not be interpreted as intending that an unclaimed disclosed feature is essential to any claim. Rather, inventive subject matter may lie in less than all features of a particular disclosed embodiment. Thus, the following claims are hereby incorporated into the Detailed Description as examples or embodiments, with each claim standing on its own as a separate embodiment, and it is contemplated that such embodiments can be combined with each other in various combinations or permutations. The scope of the invention should be determined with reference to the appended claims, along with the full scope of equivalents to which such claims are entitled.

## Claims

1. A microelectronics package comprising:
a substrate including a trace;
an acceptor in electrical communication with the trace;
a donor connected to the acceptor;
a photolithographic masking material connected to the substrate and encapsulating a portion of at least the acceptor.

2. The microelectronics package of claim 1, further comprising a lens positioned proximate an opening defined by the photolithographic masking material and exposed to the donor.

3. The microelectronics package of any one of claims 1-2, further comprising a fiber optic cable in optical communication with the donor.

4. The microelectronics package of any one of or any combination of claims 1-3, further comprising an optical engine in optical communication with the donor.

5. The microelectronics package of any one of or any combination of claims 1-4, further comprising a compute die connected to the trace.

6. The microelectronics package of any one of or any combination of claims 1-5, wherein at least one of the acceptor and the donor is an organic substrate material.

7. The microelectronics package of any one of or any combination of claims 1-6, wherein both the acceptor and the donor are not silicon-based substrates.

8. The microelectronics package of any one of or any combination of claims 1-7, wherein at least one of the acceptor and the donor comprises at least one of an alkyl thiphenes and polybuckminsterfullerene.

9. A method of manufacturing a microelectronics package, the method comprising:
forming a substrate layer having a substrate surface and a trace;
forming an acceptor layer on the substrate surface, the acceptor layer having an acceptor surface;
forming a donor layer on the acceptor surface, the donor layer having a donor surface;
encapsulating the acceptor layer and the donor layer with a solder resist material; and
forming a solder resist opening in the solder resist material to expose a portion of the donor surface.

10. The method of claim 9, wherein forming the solder resist opening comprises:
forming a dry film resist layer on the donor surface prior to encapsulating the acceptor layer and the donor layer with the solder resist material; and
removing the dry film resist layer to form the solder resist opening.

11. The method of any one of claims 9-10, further comprising positioning a lens proximate the solder resist opening.

12. The method of any one of or any combination of claims 9-11, further comprising positioning a portion of a fiber optic cable proximate the donor surface.

13. The method of any one of or any combination of claims 9-12, further comprising optically coupling an optical engine with the donor surface.

14. The method of any one of or any combination of claims 9-13, wherein forming at least one of the acceptor layer and the donor layer comprises forming the acceptor layer with an organic substrate material.

15. The method of any one of or any combination of claims 9-14, wherein both the acceptor layer and the donor layer are not silicon-based substrates.
